(19) Europäisches Patentamt
European Patent Office
Office européen des brevets

(11) **EP 4 715 817 A1**

(12) **EUROPEAN PATENT APPLICATION**
published in accordance with Art. 153(4) EPC

(43) Date of publication:
**25.03.2026 Bulletin 2026/13**

(21) Application number: **24909708.0**

(22) Date of filing: **24.07.2024**

(51) International Patent Classification (IPC):
*G11C 5/14* (2006.01)

(52) Cooperative Patent Classification (CPC):
**G11C 5/14**

(86) International application number:
**PCT/CN2024/107372**

(87) International publication number:
**WO 2025/138754 (03.07.2025 Gazette 2025/27)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **29.12.2023 CN 202311868889**

(71) Applicant: **CXMT Corporation
Hefei, Anhui 230601 (CN)**

(72) Inventor: **KENICHI, Miyamoto
Hefei, Anhui 230601 (CN)**

(74) Representative: **Gulde & Partner
Patent- und Rechtsanwaltskanzlei mbB
Berliner Freiheit 2
10785 Berlin (DE)**

(54) **DATA SENDING CIRCUIT, DATA RECEIVING CIRCUIT, AND ELECTRONIC DEVICE**

(57) The present disclosure provides a data sending circuit, a data receiving circuit, and an electronic device. The data sending circuit comprises a parallel-to-serial conversion circuit, a multi-level modulation circuit and a first transmission path; the parallel-to-serial conversion circuit is configured to convert a plurality of parallel initial data signals into serial data combinations, wherein each data combination comprises an n-bit data signal; the multi-level modulation circuit is configured to generate and output a target data signal on the basis of each data combination; and the first transmission path is coupled with the multi-level modulation circuit and is configured to transmit the target data signal to a second chip. According to the present disclosure, by means of multi-value transmission technology, a one-bit target data signal is used for the transmission of the n-bit data signal, so that the number of transmission paths can be reduced, and the transmission efficiency is improved.

FIG. 1

EP 4 715 817 A1

**Description**

**CROSS-REFERENCE TO RELATED APPLICATIONS**

The present disclosure claims priority to Chinese Patent Application No. 202311868889.0, filed with China National Intellectual Property Administration on December 29, 2023 and entitled "DATA TRANSMITTING CIRCUIT, DATA RECEIVING CIRCUIT, AND ELECTRONIC DEVICE", the content of which is incorporated herein by reference in its entirety.

**TECHNICAL FIELD**

The present disclosure relates to the field of semiconductors, and in particular, to a data transmitting circuit, a data receiving circuit, and an electronic device.

**BACKGROUND**

With the development of semiconductor technologies, semiconductor memories have been widely applied in electronic devices. Dynamic random access memory (dynamic random access memory, DRAM) is a volatile memory. Due to its fast access speed, the dynamic random access memory is often used as a high-speed cache memory (Cache). At present, the data transmission efficiency of the memory still has considerable room for improvement.

**SUMMARY**

Embodiments of the present disclosure provide a data transmitting circuit, a data receiving circuit, and an electronic device.
The technical solutions of the present disclosure are implemented as follows:
In a first aspect, the present disclosure provides a data transmitting circuit applied to a first chip. The data transmitting circuit includes:

a parallel-to-serial conversion circuit, configured to receive a plurality of parallel initial data signals, and convert, based on an initial clock signal, the plurality of parallel initial data signals into a serial data combination, where the data combination includes an n-bit data signal, and n is an integer greater than 1;
a multi-level modulation circuit, coupled to the parallel-to-serial conversion circuit and configured to receive and, based on each data combination, generate and output one target data signal, where if the n-bit data signal in the data combination forms different signal value combinations, voltage values of resulting target data signals are different; and
a first transmission path, coupled to the multi-level modulation circuit and configured to output the target data signal from the first chip.

In some embodiments, the data transmitting circuit further includes: a first reference voltage generation circuit, configured to receive a reference voltage signal, generate, based on the reference voltage signal, a preset power supply signal and an initial reference voltage signal, and output the preset power supply signal from a first output terminal of the first reference voltage generation circuit and output the initial reference voltage signal from a second output terminal of the first reference voltage generation circuit, where a voltage value of the preset power supply signal and a voltage value of the initial reference voltage signal are in a preset ratio; and the multi-level modulation circuit, coupled to the first output terminal of the first reference voltage generation circuit and further configured to receive the preset power supply signal, and generate, under driving of the preset power supply signal and based on each data combination, the target data signal.
In some embodiments, the data transmitting circuit further includes: a clock generation circuit, coupled to the parallel-to-serial conversion circuit and configured to generate the initial clock signal and output the initial clock signal through an output terminal of the clock generation circuit; a DC (direct-current) blocking circuit, connected to the output terminal of the clock generation circuit and the second output terminal of the first reference voltage generation circuit separately, and configured to transmit the initial clock signal subjected to direct-current blocking processing to the second output terminal of the first reference voltage generation circuit, so as to be superimposed with the initial reference voltage signal to generate a clock/voltage mixed signal; and a second transmission path, coupled to the second output terminal of the first reference voltage generation circuit and configured to output the clock/voltage mixed signal from the first chip.
In some embodiments, in a case that n = 2, the data combination includes a low-bit data signal and a high-bit data signal. If the low-bit data signal and the high-bit data signal form a first signal value combination, the target data signal is a first voltage value; if the low-bit data signal and the high-bit data signal form a second signal value combination, the target data signal is a second voltage value; if the low-bit data signal and the high-bit data signal form a third signal value combination, the target data signal is a third voltage value; if the low-bit data signal and the high-bit data signal form a fourth signal value combination, the target data signal is a grounding voltage; and the first voltage value, the second voltage value, the third voltage value, and the grounding voltage decrease sequentially.

In some embodiments, the multi-level modulation circuit includes a first logic unit, a first pull-up unit, a second pull-up unit, a third pull-up unit, and a pull-down unit; the multi-level modulation circuit further includes a driving source node and an output node, where the driving source node receives the preset power supply signal; the first pull-up unit, the second pull-up unit, and the third pull-up unit are connected in parallel between the driving source node and the output node; the pull-down unit is connected in series between the output node and a ground terminal, and the output node is connected to the first transmission path; and the first logic unit is configured to perform an AND operation on the low-bit data signal and the high-bit data signal to generate a first control signal, and perform a NOR operation on the low-bit data signal and the high-bit data signal to generate a second control signal, where the first control signal is configured to selectively turn on the first pull-up unit, the high-bit data signal is configured to selectively turn on the second pull-up unit, the low-bit data signal is configured to selectively turn on the third pull-up unit, the second control signal is configured to selectively turn on the pull-down unit, and the resistance values of the second pull-up unit and the third pull-up unit are different.

In some embodiments, the first pull-up unit includes a first switching transistor and a first resistor connected in series between the driving source node and the output node, the second pull-up unit includes a second switching transistor and a second resistor connected in series between the driving source node and the output node, the third pull-up unit includes a third switching transistor and a third resistor connected in series between the driving source node and the output node, and the pull-down unit includes a fourth switching transistor and a fourth resistor connected in series; and a control terminal of the first switching transistor receives the first control signal, a control terminal of the second switching transistor receives the low-bit data signal, a control terminal of the third switching transistor receives the high-bit data signal, and a control terminal of the fourth switching transistor receives the second control signal.

In some embodiments, the first voltage value:the second voltage value:the third voltage value = A:B:C, where A, B, and C are all positive integers, and A, B, and C decrease sequentially; $(R_{parallel} + R_{down}):(R_2 + R_{down}):(R_3 + R_{down})=$ (1/A):(1/B):(1/C), where $R_{parallel}$ refers to an equivalent resistor formed by connecting the first resistor, the second resistor, and the third resistor in parallel, $R_{down}$ refers to a resistance value of a pull-down resistor coupled to the first transmission path in data receiving circuit corresponding to the data transmitting circuit, $R_2$ refers to a resistance value of the second resistor, and $R_3$ refers to a resistance value of the third resistor.

In some embodiments, the first reference voltage generation circuit includes a first operational amplifier, a fifth resistor, and a sixth resistor; a positive input terminal of the first operational amplifier receives the reference voltage signal, a negative input terminal of the first operational amplifier is connected to an output terminal of the first operational amplifier, and the output terminal of the first operational amplifier serves as the first output terminal of the first reference voltage generation circuit to output the preset power supply signal; and the output terminal of the first operational amplifier is connected to a first terminal of the fifth resistor, a second terminal of the fifth resistor is connected to a first terminal of the sixth resistor, a second terminal of the sixth resistor is connected to the ground terminal, and the second terminal of the fifth resistor serves as the second output terminal of the first reference voltage generation circuit to output the initial reference voltage signal.

In some embodiments, the first transmission path and the second transmission path each include a through silicon via.

In a second aspect, the embodiments of the present disclosure provide a data receiving circuit applied to a second chip. The data receiving circuit includes:

a third transmission path, configured to receive a target data signal transmitted to the second chip;
a data comparison circuit, coupled to the third transmission path and configured to receive $(2^n - 1)$ reference voltages and the target data signal, compare a voltage value of each of the reference voltages with a voltage value of the target data signal, and generate and output $(2^n - 1)$ comparison signals; and
a logic processing circuit, coupled to the data comparison circuit and configured to perform logic processing on the $(2^n - 1)$ comparison signals to generate and output a data combination, where each data combination includes an n-bit data signal, and n is an integer greater than 1.

In some embodiments, the data receiving circuit further includes: a fourth transmission path, configured to receive a clock/voltage mixed signal transmitted to the second chip; a clock receiver, coupled to the fourth transmission path and configured to receive a clock reference voltage and a clock/voltage mixed signal, compare the clock/voltage mixed signal with the clock reference voltage, and generate and output a reference clock signal; a clock processing circuit, connected to the clock receiver and configured to receive the reference clock signal, process the reference clock signal, and then generate and output a sampling clock signal; and a logic processing circuit, further connected to the clock processing circuit and configured to sample the $(2^n - 1)$ comparison signals separately based on the sampling clock signal, and perform a logical operation based on a sampling result to generate the data combination.

In some embodiments, the data receiving circuit further includes: a low-pass filter, configured to receive the clock/voltage mixed signal and filter the clock/voltage mixed signal to generate an initial reference voltage; and a second reference voltage generation circuit, configured to generate $(2^n - 1)$ reference voltages based on the initial reference voltage.

In some embodiments, the data receiving circuit further includes a pull-down resistor; a first terminal of the pull-down resistor is connected to the third transmission path, and a second terminal of the pull-down resistor is connected to a ground terminal.

In some embodiments, in a case that n = 2, the $(2^n - 1)$ reference voltages are referred to as a first reference voltage, a second reference voltage, and a third reference voltage, respectively, and the $(2^n - 1)$ comparison signals are referred to as a first comparison signal, a second comparison signal, and a third comparison signal, respectively; a voltage value of the first reference voltage is between a first voltage value and a second voltage value, a voltage value of the second reference voltage is between the second voltage value and a third voltage value, and a voltage value of the third reference voltage is between the third voltage value and a grounding voltage; the first voltage value, the second voltage value, and the third voltage value decrease sequentially; and the logic processing circuit is specifically configured such that: if the first comparison signal indicates that the voltage value of the target data signal is greater than or equal to the voltage value of the first reference voltage, a two-bit data signal of the data combination forms a first signal value combination; or if the first comparison signal indicates that the voltage value of the target data signal is less than the voltage value of the first reference voltage and the second comparison signal indicates that the voltage value of the target data signal is greater than or equal to the voltage value of the second reference voltage, a two-bit data signal of the data combination forms a second signal value combination; or if the second comparison signal indicates that the voltage value of the target data signal is less than the voltage value of the second reference voltage and the third comparison signal indicates that the voltage value of the target data signal is greater than or equal to the voltage value of the third reference voltage, a two-bit data signal of the data combination forms a third signal value combination; or if the third comparison signal indicates that the voltage value of the target data signal is less than the voltage value of the third reference voltage, a two-bit data signal of the data combination forms a fourth signal value combination.

In some embodiments, the second reference voltage generation circuit includes a second operational amplifier, a seventh resistor, an eighth resistor, a ninth resistor, and a tenth resistor; a positive input terminal of the second operational amplifier receives the initial reference voltage, an output terminal of the second operational amplifier is connected to a first terminal of the seventh resistor, and a negative input terminal of the second operational amplifier is connected to a second terminal of the eighth resistor; a second terminal of the seventh resistor is connected to a first terminal of the eighth resistor, the second terminal of the eighth resistor is connected to a first terminal of the ninth resistor, a second terminal of the ninth resistor is connected to a first terminal of the tenth resistor, and a second terminal of the tenth resistor is connected to the ground terminal; and the second terminal of the seventh resistor outputs the first reference voltage, the second terminal of the eighth resistor outputs the second reference voltage, and the second terminal of the ninth resistor outputs the third reference voltage.

In some embodiments, the second reference voltage is the same as the initial reference voltage, and the clock reference voltage is identical to the second reference voltage; and the third transmission path and the fourth transmission path each include a through silicon via.

In a third aspect, the embodiments of the present disclosure provide an electronic device. The electronic device includes a first chip and a second chip. The first chip includes the data transmitting circuit according to the first aspect, and the second chip includes the data receiving circuit according to the second aspect.

In some embodiments, the first chip is a logic chip/memory chip, and the second chip is a memory chip/logic chip; the first chip and the second chip are stacked in a first direction, and the first direction is perpendicular to a top surface of the chip; and the electronic device is a stacked memory.

In some embodiments, the through silicon via in the first transmission path of the first chip and the through silicon via in the third transmission path of the second chip are aligned in the first direction and form a transmission path for the target data signal; and the through silicon via in the second transmission path of the first chip and the through silicon via in the fourth transmission path of the second chip are aligned in the first direction and form a transmission path for the clock/voltage mixed signal.

The embodiments of the present disclosure provide a data transmitting circuit, a data receiving circuit, and an electronic device. By means of the multi-value transmission technology, a one-bit target data signal is used to transmit the n-bit data signal, and the target data signal has at least $2^n$ voltage values, thereby reducing the number of transmission paths and improving the transmission efficiency.

**BRIEF DESCRIPTION OF DRAWINGS**

FIG. 1 is a schematic structural diagram of a data transmitting circuit according to an embodiment of the present disclosure;

FIG. 2 is a specific schematic structural diagram of a data transmitting circuit according to an embodiment of the present disclosure;

FIG. 3 is a schematic diagram illustrating a voltage of a target data signal according to an embodiment of the present disclosure;

FIG. 4 is a schematic structural diagram of a multi-level modulation circuit according to an embodiment of the present disclosure;

FIG. 5 is a schematic structural diagram of a data receiving circuit according to an embodiment of the present disclosure;

FIG. 6 is a specific schematic structural diagram of a data receiving circuit according to an embodiment of the present disclosure;

FIG. 7A/7B/7C is a schematic structural diagram of an electronic device according to an embodiment of the present disclosure; and

FIG. 8 is a specific schematic structural diagram of an electronic device according to an embodiment of the present disclosure.

**DESCRIPTION OF EMBODIMENTS**

In order to make the objects, technical solutions, and advantages of the present disclosure clearer, the technical solutions of the present disclosure are further elaborated below with reference to the drawings and embodiments. The described embodiments should not be construed as limiting the present disclosure, and all other embodiments obtained by a person of ordinary skill in the art without making creative efforts fall within the protection scope of the present disclosure.

In the following description, reference is made to "some embodiments", which describe subsets of all possible embodiments, but it can be understood that "some embodiments" may be the same subset or different subsets of all possible embodiments, and may be combined with each other without conflict.

If the application document contains descriptions such as "first/second", the following explanation is added: In the following description, the terms "first/second/third" are used merely to distinguish similar objects and do not imply a specific order of the objects. It can be understood that "first/second/third" may be interchanged with a specific order or sequence if permitted, such that the embodiments of the present disclosure described herein can be implemented in an order other than that shown or described herein.

Unless otherwise defined, all technical and scientific terms used herein have the same meaning as commonly understood by those skilled in the art to which the present disclosure belongs. The terms used herein are for the purpose of describing the embodiments of the present disclosure only and are not intended to limit the present disclosure.

The embodiments of the present disclosure are described in detail hereinafter with reference to the drawings.

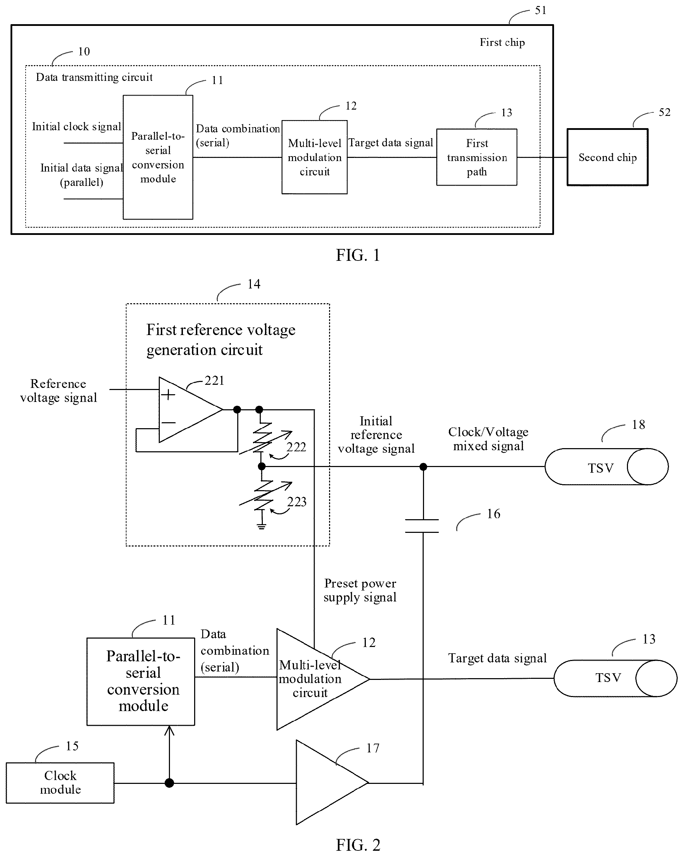

In an embodiment of the present disclosure, a data transmitting circuit 10 is provided. The data transmitting circuit is applied to a first chip 51. Referring to FIG. 1, the data transmitting circuit 10 includes:

a parallel-to-serial conversion circuit 11 configured to receive a plurality of parallel initial data signals, and convert, based on an initial clock signal, the plurality of parallel initial data signals into a serial data combination, where the data combination includes an n-bit data signal, and n is an integer greater than 1;

a multi-level modulation circuit 12 coupled to the parallel-to-serial conversion circuit 11 and configured to receive and, based on each data combination, generate and output one target data signal, where if the n-bit data signal in the data combination forms different signal value combinations, voltage values of resulting target data signals are different; and

a first transmission path 13 coupled to the multi-level modulation circuit 12 and configured to output the target data signal from the first chip 51.

Illustratively, the first chip 51 is electrically connected to the second chip 52, and the first transmission path 13 specifically transmits the target data signal to the second chip 52.

It should be noted that the parallel-to-serial conversion circuit 11 can convert the parallel initial data signals into a serial data combination, and the number of the initial data signals is greater than n. For example, the initial data signal may be DataIn<7:0>, where n = 2; that is, the data combination is represented as Data<1:0>, and parallel-to-serial conversion means that DataIn<1:0> is used as the data combination for clock cycle T0, DataIn<3:2> is used as the data combination for clock cycle T1, DataIn<5:4> is used as the data combination for clock cycle T2, and DataIn<7:6> is used as the data combination for clock cycle T3, and so on. For another example, the initial data signal may be DataIn<15:0>, which may also be considered as converting the parallel initial data signal DataIn<7:0> into the serial Data<0> and converting the parallel initial data signal DataIn<15:8> into the serial Data<1>. The above are merely examples, and the number of the initial data signals and the value of n may be selected as needed. The parallel-to-serial conversion circuit 11 may be implemented by using a flip-flop DFF, a first-in first-out data storage FIFO, or the like.

It should be further noted that the multi-level modulation circuit 12 can generate a target data signal having a corresponding voltage value based on a specific signal value of the data combination, and the target data signal is only a one-bit signal. Meanwhile, each data signal in the data combination has a signal value of 1 (high level) or 0 (low level), but the target data signal has at least $2^n$ voltage values, such that the value of the n-bit data signal can be indicated by using only a one-bit target data signal. As a result, the number of transmission paths is reduced, and the transmission efficiency is significantly improved.

In some embodiments, referring to FIG. 2, the data transmitting circuit 10 further includes:

a first reference voltage generation circuit 14 configured to receive a reference voltage signal, generate, based on the reference voltage signal, a preset power supply signal and an initial reference voltage signal, and output the preset power supply signal from a first output terminal of the first reference voltage generation circuit and output the initial reference voltage signal from a second output terminal of the first reference voltage generation circuit, where the voltage value of the preset power supply signal and the voltage value of the initial reference voltage signal are in a preset ratio; and

the multi-level modulation circuit 12 coupled to the first output terminal of the first reference voltage generation circuit 14 and further configured to receive the preset power supply signal, and generate, under driving of the preset power supply signal and based on each data combination, the target data signal.

Here, the voltage value of the target data signal is positively correlated with the voltage value of the preset power supply signal.

It should be noted that the initial reference voltage signal needs to be transmitted to the second chip 52 synchronously with the target data signal, such that the second chip 52 generates $(2^n - 1)$ reference voltages based on the initial reference voltage signal, then compares the voltage value of the target data signal with these $(2^n - 1)$ reference voltages, and finally decodes, based on the comparison results, n data signals (i.e., the specific signal values of the data combination).

In some embodiments, referring to FIG. 2, the data transmitting circuit 10 further includes:

a clock generation circuit 15 coupled to the parallel-to-serial conversion circuit 11 and configured to generate the initial clock signal and output the initial clock signal through an output terminal of the clock generation circuit;

a DC (direct-current) blocking circuit 16 connected to the output terminal of the clock generation circuit 15 and the second output terminal of the first reference voltage generation circuit 14 separately, and configured to transmit the initial clock signal subjected to direct-current blocking processing to the second output terminal of the first reference voltage generation circuit 14, so as to be superimposed with the initial reference voltage signal to generate a clock/voltage mixed signal; and

a second transmission path 18 coupled to the second output terminal of the first reference voltage generation circuit 14 and configured to output the clock/voltage mixed signal from the first chip 51.

It should be noted that the initial clock signal also needs to be transmitted to the second chip 52 synchronously with the target data signal, such that the second chip 52 can sample the target data signal based on the initial clock signal. To improve the transmission efficiency, in the present disclosure, the initial clock signal subjected to direct-current blocking processing is superimposed with the initial reference voltage signal to generate the clock/voltage mixed signal, which is then transmitted to the second chip 52. Subsequently, the second chip 52 processes the clock/voltage mixed signal to obtain the information carried by the initial clock signal and the information carried by the initial reference voltage signal. This is equivalent to that the information carried by the initial clock signal and the information carried by the initial reference voltage signal can be transmitted to the second chip 52 by using only one transmission path, which not only reduces the number of transmission paths and reduces the area occupied by the chip, but also improves the transmission efficiency.

Here, the functions of the DC blocking circuit 16 at least include: (1) 1. A direct-current reference voltage is prevented from being transmitted to the output terminal of the clock generation circuit; and (2) an alternating-current clock signal is transmitted to the output terminal of the first reference voltage generation circuit while direct-current noise is filtered.

Referring to FIG. 2, the data transmitting circuit 20 may further include a buffer 17. After passing through the buffer 17 and the DC blocking circuit 16, the initial clock signal is superimposed with the initial reference voltage signal to form a clock/voltage reference signal.

In some embodiments, in a case where n = 2, the data combination includes a low-bit data signal Data<0> and a high-bit data signal Data<1>. In this case, the multi-level modulation circuit 12 may be implemented by the 4 pulse amplitude modulation (4 pulse amplitude modulation, PAM4) technology. By using four different signal levels for logic signal transmission, the logical information of a two-bit data signal (00, 01, 10, 11) can be transmitted per clock cycle. Therefore, at the same baud rate (with the same symbol period), the bit rate of the PAM4 signal is twice that of the conventional signal, thereby doubling the transmission rate. In addition, in some embodiments, in the case that n is a value greater than 2, the multi-level modulation circuit corresponds to other pulse amplitude modulation modes. For example, n = 3 corresponds to PAM8, and n = 4 corresponds to PAM16.

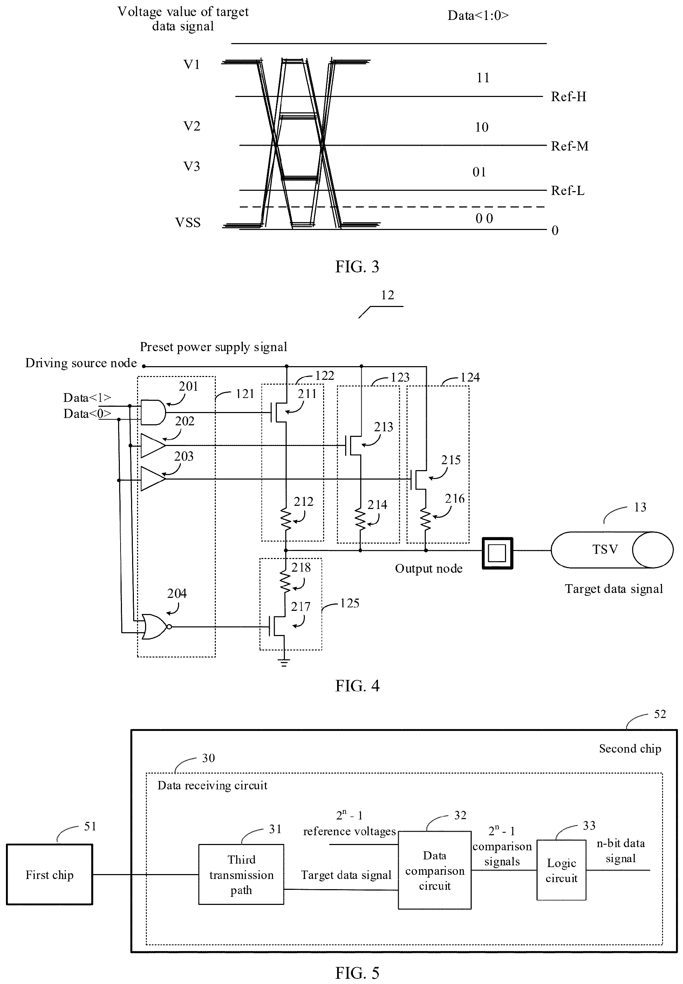

Referring to FIG. 3, if the low-bit data signal and the high-bit data signal form a first signal value combination (e.g., Data<1:0>=11), the target data signal is a first voltage value V1; if the low-bit data signal and the high-bit data signal form a second signal value combination (e.g., Data<1:0>=10), the target data signal is a second voltage value V2; if the low-bit data signal and the high-bit data signal form a third signal value combination (e.g., Data<1:0>=01), the target data signal is a third voltage value V3; and if the low-bit data signal and the high-bit data signal form a fourth signal value combination (e.g., Data<1:0>=00), the target data signal is a grounding voltage VSS.

Illustratively, the first voltage value V1, the second voltage value V2, the third voltage value V3, and the grounding voltage VSS decrease sequentially.

It should be understood that the target data signal is the grounding voltage VSS, which may be simply understood as the absence of signal transmission. In this way, power resources can be saved.

Certainly, in other embodiments, if the low-bit data signal and the high-bit data signal form a fourth signal value combination (e.g., Data<1:0>=00), the target data signal may also be set to a fourth voltage value greater than the grounding voltage.

In this case, referring to FIG. 4, the multi-level modulation circuit 12 includes a first logic unit 121, a first pull-up unit 122, a second pull-up unit 123, a third pull-up unit 124, and a pull-down unit 125. The multi-level modulation circuit 12 further includes a driving source node and an output node, where the driving source node receives the preset power supply signal. The first pull-up unit 122, the second pull-up unit 123, and the third pull-up unit 124 are connected in parallel between the driving source node and the output node, and the pull-down unit 125 is connected in series between the output node and the ground terminal, and the output node is connected to the first transmission path 13. The first logic unit 121 is configured to perform an AND operation on the low-bit data signal Data<0> and the high-bit data signal Data<1> to generate a first control signal, and perform a NOR operation on the low-bit data signal Data<0> and the high-bit data signal Data<1> to generate a second control signal.

The first control signal is configured to selectively turn on the first pull-up unit 122, the high-bit data signal Data<1> is configured to selectively turn on the second pull-up unit 123, the low-bit data signal Data<0> is configured to selectively turn on the third pull-up unit 124, the second control signal is configured to selectively turn on the pull-down unit 125, and the resistance values of the second pull-up unit 123 and the third pull-up unit 124 are different.

It should be noted that the first logic unit 121 includes an AND gate 201, a first buffer 202, a second buffer 203, and a NOR gate 204. The AND gate 201 is configured to perform an AND operation on the low-bit data signal Data<0> and the high-bit data signal Data<1> to generate the first control signal, and the NOR gate 204 is configured to perform a NOR operation on the low-bit data signal Data<0> and the high-bit data signal Data<1> to generate the second control signal. The first buffer 202 is configured to delay the high-bit data signal Data<1> and then transmit the delayed high-bit data signal to the second pull-up unit 123, and the second buffer 203 is configured to delay the low-bit data signal Data<0> and then transmit the delayed low-bit data signal to the third pull-up unit 124. The primary function of the first buffer 202 and the second buffer 203 is to achieve delay matching of the signals.

In some embodiments, referring to FIG. 4, the first pull-up unit 122 includes a first switching transistor 211 and a first resistor 212 connected in series between the driving source node and the output node, the second pull-up unit 123 includes a second switching transistor 213 and a second resistor 214 connected in series between the driving source node and the output node, the third pull-up unit 124 includes a third switching transistor 215 and a third resistor 216 connected in series between the driving source node and the output node, and the pull-down unit 125 includes a fourth switching transistor 217 and a fourth resistor 218 connected in series.

A control terminal of the first switching transistor 211 receives the first control signal, a control terminal of the second switching transistor 213 receives the (delayed) low-bit data signal Data<0>, a control terminal of the third switching transistor 215 receives the (delayed) high-bit data signal Data<1>, and a control terminal of the fourth switching transistor 217 receives the second control signal.

In some embodiments, the first voltage value V1:the second voltage value V2:the third voltage value V3 = A:B:C, where A, B, and C are all positive integers, and A, B, and C decrease sequentially;

$$1/(R_{parallel} + R_{down}):1/(R_2 + R_{down}):1/(R_3 + R_{down}) = A:B:C,$$

where $R_{parallel}$ refers to an equivalent resistance formed by connecting the first resistor 212, the second resistor 214, and the third resistor 216 in parallel, $R_{down}$ refers to a resistance value of a pull-down resistor coupled to the first transmission path 13 in a data receiving circuit (in the second chip 52), $R_2$ refers to a resistance value of the second resistor 214, and $R_3$ refers to a resistance value of the third resistor 216.

Illustratively, the first voltage value V1:the second voltage value V2:the third voltage value V3 = 3:2:1. In a possible value, $R_1 = 60\,\Omega$, $R_2 = 100\,\Omega$, $R_3 = 300\,\Omega$, and $R_{down} = 100\,\Omega$. In this case, $R_{parallel} = 33.33\,\Omega$, $(R_{parallel} + R_{down}):(R_2 + R_{down}):(R_3 + R_{down}) = 3:2:1$. Alternatively, $R_1 = 170\,\Omega$, $R_2 = 150\,\Omega$, $R_3 = 400\,\Omega$, and $R_{down} = 100\,Q$. In this case, $R_{parallel} = 66.45\,\Omega$, $(R_{parallel} + R_{down}):(R_2 + R_{down}):(R_3 + R_{down}) = 3:2:1$.

In some embodiments, referring to FIG. 2, the first reference voltage generation circuit 14 includes a first operational amplifier 221, a fifth resistor 222, and a sixth resistor 223. A positive input terminal of the first operational amplifier 221 receives the reference voltage signal, a negative input terminal of the first operational amplifier 221 is connected to an output terminal of the first operational amplifier 221, and the output terminal of the first operational amplifier 221 serves as the first output terminal of the first reference voltage generation circuit 14 to output the preset power supply signal. The output terminal of the first operational amplifier 221 is connected to a first terminal of the fifth resistor 222, a second terminal of the fifth resistor 222 is connected to a first terminal of the sixth resistor 223, a second terminal of the sixth resistor 223 is connected to the ground terminal, and the second terminal of the fifth resistor 222 serves as the second output terminal of the first reference voltage generation circuit 14 to output the initial reference voltage signal.

It should be understood that, after the first reference voltage generation circuit 14 reaches equilibrium, the voltage at a positive-phase input terminal of the first operational amplifier 221 is the same as the voltage at a negative-phase input terminal of the first operational amplifier; that is, the voltage of the preset power supply signal is the same as the voltage of the reference voltage signal. The voltage of the initial reference voltage signal:the voltage of the preset power supply signal = resistance value of the sixth resistor 223:(resistance value of the fifth resistor 222 + resistance value of the sixth resistor 223). In addition, the first reference voltage generation circuit 14 may also be implemented by using other voltage divider structures.

Here, both the fifth resistor 222 and the sixth resistor 223 are adjustable resistors. In this case, the voltage of the initial reference voltage signal is adjustable.

In some embodiments, the first transmission path 13 and the second transmission path 18 each include a through silicon via (through silicon via, TSV).

It should be noted that the TSV belongs to the vertical electrical interconnection technology that enables vertical conduction between chips and between wafers. The TSV features a small form factor, which can increase the stacking density and improve the chip speed and low power consumption performance.

The embodiments of the present disclosure provide a data transmitting circuit. At present, for a memory chip, the increase in electrical bonding pads has become a problem due to high-bandwidth data transmission, which leads to a larger chip size and an inter-chip connection failure. The embodiments of the present disclosure reduce the number of electrical bonding pads by performing multi-value transmission using a single signal (the target data signal) through the multi-level modulation technology. In brief, for conventional single-value transmission, one-bit data is transmitted per clock cycle (one-bit data is transmitted per half a clock cycle in a double data rate memory DDR); for multi-value transmission, n-bit data is transmitted per clock cycle (n-bit data is transmitted per half a clock cycle in the DDR), thereby reducing the number of electrical bonding pads and improving the transmission efficiency. In addition, the driver (the pull-up unit and the pull-down unit) in this solution can change the output current value based on the output data. Even if no current is output, the data remains valid. In this case, the data is defined as 00 data, thereby saving the transmission energy consumption. In addition, the reference voltage signal used for multi-value reference and the initial clock signal are superimposed and then transmitted through the same electrical bonding pad (for example, a micro bump pad corresponding to the TSV). Meanwhile, the reference voltage of the receiver corresponding to the second chip 52 may be independently adjusted based on the receivable tolerance, thereby further reducing the number of electrical bonding pads and improving the transmission efficiency.

In another embodiment of the present disclosure, a data receiving circuit 30 is provided. The data receiving circuit 30 is applied to a second chip 52. Referring to FIG. 5, the data receiving circuit 30 includes:

a third transmission path 31 configured to receive a target data signal transmitted to the second chip 52;
a data comparison circuit 32 coupled to the third transmission path 31 and configured to receive $(2^n - 1)$ reference voltages and the target data signal, compare the voltage value of each of the reference voltages with the voltage value of the target data signal, and generate and output $(2^n - 1)$ comparison signals; and
a logic processing circuit 33 coupled to the data comparison circuit 32 and configured to perform logic processing on the $(2^n - 1)$ comparison signals to generate and output a data combination, where each data combination includes an n-bit data signal, and n is an integer greater than 1.

It should be noted that the voltage value of the target data signal has $2^n$ values, and the data comparison circuit 32 may include $(2^n - 1)$ data comparators. Each data comparator receives the target data signal and one of the reference voltages, and outputs a corresponding comparison signal.

In this way, the data comparison circuit 32 and the logic processing circuit 33 are also referred to as a demodulation module, which can demodulate the target data signal having $2^n$ values into an n-bit data signal. Each bit of the data signal has only 2 voltage values, i.e., 0 or 1. Therefore, the value of the n-bit data signal can be indicated using only a one-bit target data signal, and only one transmission path is occupied, such that the transmission efficiency is significantly improved.

Illustratively, all of the $(2^n - 1)$ comparison signals being 0 indicates one value of the n-bit data signal in the data combination; only one of the $(2^n - 1)$ comparison signals being 1 indicates another value of the n-bit data signal in the data combination; only two of the $(2^n - 1)$ comparison signals being 1 indicates yet another value of the n-bit data signal in the data combination; ...; and all of the $(2^n - 1)$ comparison signals being 1 indicates still another value of the n-bit data signal in the data combination.

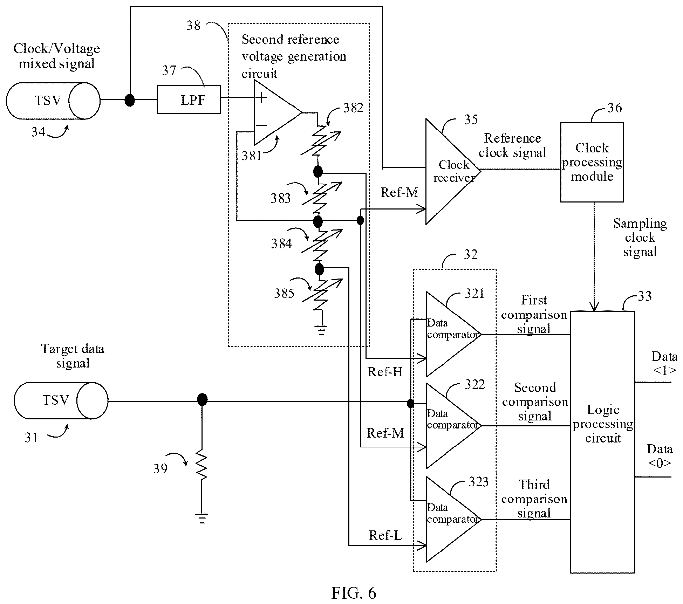

In some embodiments, as shown in FIG. 6, the data receiving circuit 30 further includes:

a fourth transmission path 34 configured to receive a clock/voltage mixed signal transmitted to the second chip 52;
a clock receiver 35 coupled to the fourth transmission path 34 and configured to receive a clock reference voltage and a clock/voltage mixed signal, compare the clock/voltage mixed signal with the clock reference voltage, and generate and output a reference clock signal;
a clock processing circuit 36 configured to receive the reference clock signal, process the reference clock signal, and then generate and output a sampling clock signal; and
a logic processing circuit 33 further connected to the clock receiver 35 and configured to sample the $(2^n - 1)$ comparison signals separately based on the sampling clock signal, and perform a logical operation based on a sampling result to generate the aforementioned data combination (that is, restore the data combination transmitted by the first chip 51). It should be understood that FIG. 6 is illustrated with n = 2 as an example, and the data combination is represented as Data<1:0>.

It should be noted that the clock processing circuit 36 may be a delay locked loop (delay locked loop, DLL).

Here, the logic processing circuit 33 may utilize the sampling clock signal to sample and latch the comparison signal output by the data comparison circuit 32, and then output an n-bit data signal after the subsequent logical operation (decoding). In some other embodiments, the sampling clock signal may also be transmitted to the data comparison circuit 32; the data comparison circuit 32 sequentially samples and compares, based on the sampling clock signal, the serial target data signal transmitted by the first chip 51, and then outputs the comparison signal; and the logic processing circuit 33 performs a logical operation on the comparison signal and then outputs the comparison signal.

In some embodiments, referring to FIG. 6, the data receiving circuit 30 further includes:

a low-pass filter 37 configured to receive the clock/voltage mixed signal and filter the clock/voltage mixed signal to generate an initial reference voltage; and
a second reference voltage generation circuit 38 configured to generate $(2^n - 1)$ reference voltages based on the initial reference voltage: In the case that n = 2, the reference voltages are Ref-H, Ref-M, and Ref-L.

It should be noted that the low-pass filter 37 (low-pass filter, LPF) is an electronic filter device that allows signals having a frequency lower than the cut-off frequency to pass through, but blocks signals having a frequency higher than the cut-off frequency. In brief, the clock/voltage mixed signal carries the alternating-current clock information and the direct-current reference voltage information. The direct-current initial reference voltage can be restored from the clock/voltage mixed signal through the low-pass filter 37, and the alternating-current sampling clock signal can be restored from the clock/voltage mixed signal through the comparison processing of the clock receiver 35. In this way, only one transmission path is required to transmit the clock information and the reference voltage information to the second chip 52 by using the clock/voltage mixed signal, thereby improving the transmission efficiency.

In some embodiments, referring to FIG. 6, the data receiving circuit 30 further includes a pull-down resistor 39.

A first terminal of the pull-down resistor 39 is connected to the third transmission path 31, and a second terminal of the pull-down resistor 39 is connected to a ground terminal.

Here, the resistance value of the pull-down resistor 39 is the aforementioned $R_{down}$; that is, the pull-down resistor 39 and the first pull-up unit, and/or the second pull-up unit, and/or the third pull-up unit in the first chip 51 form a voltage divider relationship.

In some embodiments, in the case that n = 2, the $(2^n - 1)$ reference voltages are referred to as a first reference voltage Ref-H, a second reference voltage Ref-M, and a third reference voltage Ref-L, respectively; the $(2^n - 1)$ comparison signals are referred to as a first comparison signal, a second comparison signal, and a third comparison signal, respectively; and the n-bit data signals are referred to as a high-bit data signal Data<1> and a low-bit data signal Data<0>, respectively. In addition, the data comparison circuit 32 includes data comparators 321 to 323. The data comparator 321 is configured to perform voltage comparison between the first reference voltage Ref-H and the target data signal to output the first comparison signal, the data comparator 322 is configured to perform voltage comparison between the second reference voltage Ref-M and the target data signal to output the second comparison signal, and the data comparator 323 is configured to perform voltage comparison between the third reference voltage Ref-L and the target data signal to output the third comparison signal.

Referring to FIG. 3, the voltage value of the first reference voltage Ref-H is between the first voltage value V1 and the second voltage value V2, the voltage value of the second reference voltage Ref-M is between the second voltage value V2 and the third voltage value V3, and the voltage value of the third reference voltage Ref-L is between the third voltage value V3 and the grounding voltage (or the fourth voltage value). The first voltage value V1, the second voltage value V2, and the third voltage value V3 decrease sequentially.

The logic processing circuit 33 is specifically configured such that: if the first comparison signal indicates that the voltage value (close to the first voltage value V1) of the target data signal is greater than or equal to the voltage value of the first reference voltage Ref-H, a two-bit data signal of the data combination forms a first signal value combination Data<1:0>=11; or if the first comparison signal indicates that the voltage value (close to the second voltage value V2) of the target data signal is less than the voltage value of the first reference voltage Ref-H and the second comparison signal indicates that the voltage value of the target data signal is greater than or equal to the voltage value of the second reference voltage Ref-M, a two-bit data signal of the data combination forms a second signal value combination Data<1:0>=10; or if the second comparison signal indicates that the voltage value (close to the third voltage value V3) of the target data signal is less than the voltage value of the second reference voltage Ref-M and the third comparison signal indicates that the voltage value of the target data signal is greater than or equal to the voltage value of the third reference voltage Ref-L, a two-bit data signal of the data combination forms a third signal value combination Data<1:0>=01; or if the third comparison signal indicates that the voltage value (close to the grounding voltage) of the target data signal is less than the voltage value of the third reference voltage Ref-L, a two-bit data signal of the data combination forms a fourth signal value combination Data<1:0>=00.

In some embodiments, the second reference voltage generation circuit 38 includes a second operational amplifier 381, a seventh resistor 382, an eighth resistor 383, a ninth resistor 384, and a tenth resistor 385.

A positive input terminal of the second operational amplifier 381 receives the initial reference voltage, an output terminal of the second operational amplifier 381 is connected to a first terminal of the seventh resistor 382, and a negative input terminal of the second operational amplifier 381 is connected to a second terminal of the eighth resistor 383.

A second terminal of the seventh resistor 382 is connected to a first terminal of the eighth resistor 383, the second terminal of the eighth resistor 383 is connected to a first terminal of the ninth resistor 384, a second terminal of the ninth resistor 384 is connected to a first terminal of the tenth resistor 385, and a second terminal of the tenth resistor 385 is connected to the ground terminal.

The second terminal of the seventh resistor 382 outputs the first reference voltage Ref-H, the second terminal of the eighth resistor 383 outputs the second reference voltage Ref-M, and the second terminal of the ninth resistor 384 outputs the third reference voltage Ref-L.

It should be noted that, the first reference voltage Ref-H:the second reference voltage Ref-M:the third reference voltage Ref-L = $(R_8 + R_9 + R_{10}):(R_9 + R_{10}):R_{10}$, where $R_8$ indicates the resistance value of the eighth resistor 383, $R_9$ indicates the resistance value of the ninth resistor 384, and $R_{10}$ indicates the resistance value of the tenth resistor 385.

In addition, the seventh resistor 382 to the tenth resistor 385 may be adjustable resistors, such that the specific values of the first reference voltage Ref-H, the second reference voltage Ref-M, and the third reference voltage Ref-L may be flexibly adjusted. In addition, the sensitivity of the data receiving circuit 30 can be adjusted through the specific value of the third reference voltage Ref-L. Referring to FIG. 3, if the third reference voltage Ref-L is shifted down to the dotted line position, the data receiving circuit 30 senses Data<1:0>=01 more sensitively.

In particular, in the embodiments of the present disclosure, the data output, i.e., Data<1:0>=00, is still present even when the target data signal is the grounding voltage. In addition, the sensing of 00 is the easiest process, thereby ensuring the transition of the sensing margin from 00 to 01.

It should be understood that, after the second reference voltage generation circuit 38 reaches equilibrium, the voltage at a positive-phase input terminal of the second operational amplifier 381 is the same as the voltage at a negative input terminal of the second operational amplifier, and is the same as the second reference voltage Ref-M. That is, the voltage of the second reference voltage Ref-M is the same as the voltage of the initial reference voltage. In this case, the clock reference voltage may reuse the second reference voltage Ref-M, thereby simplifying the circuit logic.

In some embodiments, the third transmission path 31 and the fourth transmission path 34 each include a TSV.

The embodiments of the present disclosure provide a data receiving circuit, which reduces the number of electrical bonding pads through transmission. That is, only a one-bit target data signal is received, the target data signal has at least $2^n$ voltage values, and the n-bit data signal is obtained by demodulating the target data signal, thereby improving the transmission efficiency. In addition, even if the target data signal has no current output, the data remains valid, i.e., in the 00 state, thereby saving the transmission energy. Moreover, by receiving the clock/voltage mixed signal, the clock information and the reference voltage information are obtained simultaneously, thereby further reducing the number of electrical bonding pads and improving the transmission efficiency. Furthermore, compared with the conventional dual-port differential transmission circuit, the single-ended transmission mode is adopted in the present disclosure, resulting in a small circuit size, reduced current consumption, and decreased consumption of TSVs/bonding pads associated with differential transmission.

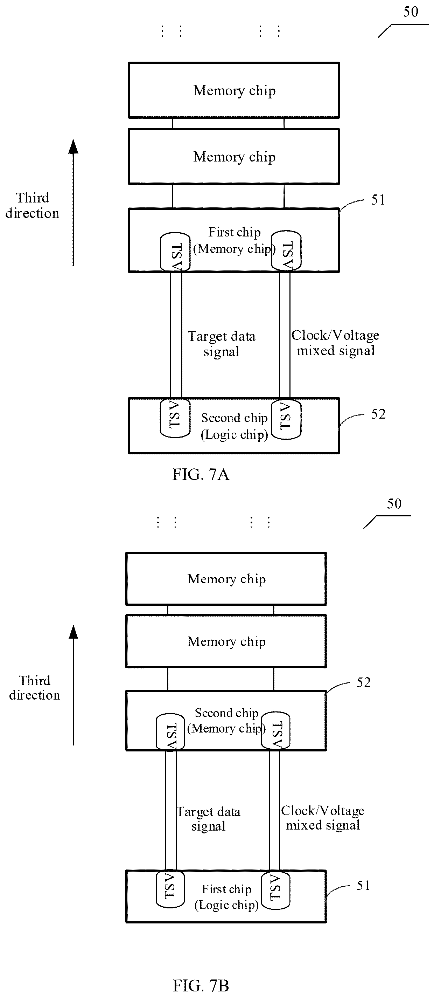

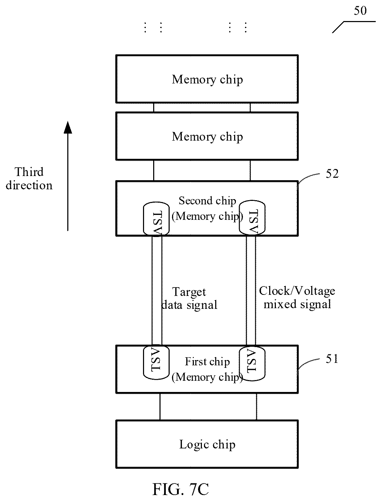

In yet another embodiment of the present disclosure, referring to FIG. 7A, FIG. 7B, and FIG. 7C, schematic structural diagrams of an electronic device 50 according to an embodiment of the present disclosure are shown. As shown in FIG. 7A, FIG. 7B, and FIG. 7C, the electronic device includes a first chip 51 and a second chip 52. The first chip 51 includes the aforementioned data transmitting circuit 10, and the second chip 52 includes the aforementioned data receiving circuit 30.

A semiconductor chip may include the top surface at the front side and the bottom surface at the back side opposite the front side. A direction intersecting (for example, perpendicular to) the top surface and bottom surface of the semiconductor chip is defined as a first direction, without considering the flatness of the top surface and bottom surface.

It should be noted that the electronic device 50 is a multi-chip stack structure (i.e., a stacked memory), which includes a logic chip and a plurality of memory chips stacked in the first direction. Referring to FIG. 7A, FIG. 7B, and FIG. 7C, the first chip 51 may be a logic chip or any memory chip in the stack structure, and the corresponding second chip 52 may be any memory chip or logic chip in the stack structure. In this case, the first chip 51 and the second chip 52 are stacked in the first direction, and the first direction is perpendicular to the top surface of the chips.

In addition, the first chip 51 may also be a single memory chip, and the second chip 52 may be a memory controller.

It should be further noted that both the first chip 51 and the second chip 52 may be provided with the data transmitting circuit 10 and the data receiving circuit 30.

The through silicon via TSV in the first transmission path of the first chip 51 and the through silicon via TSV in the third transmission path of the second chip 52 are aligned in the first direction and form a transmission path for the target data signal.

The through silicon via TSV in the second transmission path of the first chip 51 and the through silicon via TSV in the fourth transmission path of the second chip 52 are aligned in the first direction and form a transmission path for the clock/voltage mixed signal.

The embodiments of the present disclosure relate to semiconductor circuit designs and are not limited to specific interface applications. They can be applied in scenarios where there is a need to transmit and receive signals.

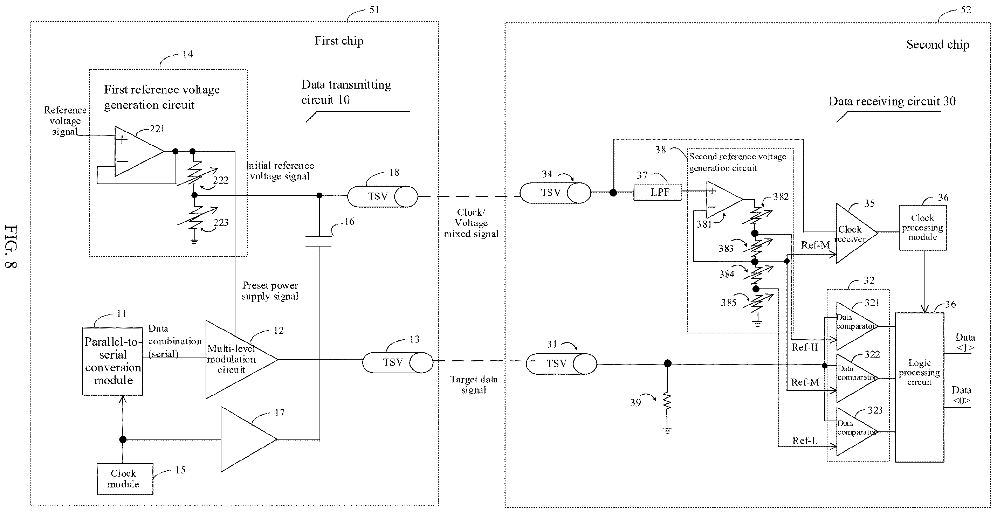

Referring to FIG. 8, a schematic structural diagram of a data transmitting-receiving circuit of an electronic device is provided. As shown in FIG. 8, the operation process of the data transmitting circuit 10 in the first chip 51 is as follows: (1) The clock generation circuit 15 generates an initial clock signal, the first reference voltage generation circuit 14 generates an initial reference voltage signal and a preset power supply signal by using the reference voltage signal, the initial reference voltage signal is superimposed with the initial clock signal subjected to direct-current blocking processing to form a clock/voltage mixed signal, and the clock/voltage mixed signal is transmitted to the second chip 52 through the first transmission path to the third transmission path; and (2) The parallel-to-serial conversion circuit 11 converts a plurality of parallel initial data signals into a serial data combination by using the initial clock signal, where the data combination includes an n-bit data signal (illustrated with n = 2 as an example); and the multi-level modulation circuit 12 modulates, under driving of the preset power supply signal, the n-bit data signal into a target data signal having $2^n$ level values, and the target data signal is transmitted to the second chip 52 through the second transmission path to the fourth transmission path.

The operation process of the data receiving circuit 50 in the second chip 52 is as follows: (1) The low-pass filter 37 is used to filter the clock/voltage mixed signal to generate an initial reference voltage, the second reference voltage generation circuit 38 generates, based on the initial reference voltage, the first reference voltage Ref-H, the second reference voltage Ref-M, and the third reference voltage Ref-L, and the voltage value of the second reference voltage Ref-M is the same as the voltage value of the initial reference voltage; and the clock receiver 35 generates a reference clock signal by performing voltage comparison between the clock/voltage mixed signal and the second reference voltage Ref-M, and the clock processing circuit 36 generates a sampling clock signal based on the reference clock signal; and (2) The data comparison circuit 32 performs voltage comparison between the target data signal and the first reference voltage Ref-H, the second reference voltage Ref-M, and the third reference voltage Ref-L separately, and the logic processing circuit 33 samples, latches, and decodes the voltage comparison result based on the sampling clock signal, to obtain the original data combination transmitted by the first chip 51.

The embodiments of the present disclosure provide an electronic device, in which a one-bit target data signal is used to transmit the n-bit data signal, and the target data signal has at least $2^n$ voltage values, thereby reducing the number of transmission paths and improving the transmission efficiency. Meanwhile, even if the target data signal has no current output, the data remains valid, i.e., in the 00 state, thereby saving the transmission energy. In addition, the clock information and the reference voltage information are simultaneously transmitted through the clock/voltage mixed signal, thereby further reducing the number of transmission paths and improving the transmission efficiency.

It should be noted that the terms "includes", "including", "comprises", "comprising", or any other variants are intended to cover non-exclusive inclusion herein. Thus, a process, method, item, or apparatus including a series of elements includes not only those elements but also other elements not explicitly listed, or elements inherent to such process, method, item, or apparatus. Without further limitation, an element defined by the phrase "including a..." does not exclude the presence of additional identical elements in the process, method, item, or apparatus that includes the element.

The serial numbers of the embodiments of the present disclosure described above are for the purpose of describing only and do not represent the superiority or inferiority of the embodiments. The methods disclosed in the method embodiments provided in the present disclosure may be combined in any manner without conflict to obtain new method embodiments. The features disclosed in the product embodiments provided in the present disclosure may be combined in any manner without conflict to obtain new product embodiments. The features disclosed in the method or device embodiments provided in the present disclosure may be combined in any manner without conflict to obtain new method or device embodiments.

The above description is only the specific embodiments of the present disclosure, but the protection scope of the present disclosure is not limited thereto; changes or substitutions that any of those skilled in the art can easily think of within the technical scope disclosed by the present disclosure shall all fall within the protection scope of the present disclosure. Therefore, the protection scope of the present disclosure shall be subject to the protection scope of the claims.

## Claims

1. A data transmitting circuit (10), applied to a first chip (51), the data transmitting circuit (10) comprising:

   a parallel-to-serial conversion circuit (11), configured to receive a plurality of parallel initial data signals, and convert, based on an initial clock signal, the plurality of parallel initial data signals into a serial data combination, wherein the data combination comprises an n-bit data signal, and n is an integer greater than 1;
   a multi-level modulation circuit (12), coupled to the parallel-to-serial conversion circuit (11) and configured to receive and, based on each data combination, generate and output one target data signal, wherein if the n-bit data signal in the data combination forms different signal value combinations, voltage values of resulting target data signals are different; and
   a first transmission path (13), coupled to the multi-level modulation circuit (12) and configured to output the target data signal from the first chip (51).

2. The data transmitting circuit (10) according to claim 1, the data transmitting circuit (10) further comprising:

   a first reference voltage generation circuit (14), configured to receive a reference voltage signal, generate, based on the reference voltage signal, a preset power supply signal and an initial reference voltage signal, and output the preset power supply signal from a first output terminal of the first reference voltage generation circuit and output the initial reference voltage signal from a second output terminal of the first reference voltage generation circuit, wherein a voltage value of the preset power supply signal and a voltage value of the initial reference voltage signal are in a preset ratio; and
   the multi-level modulation circuit (12), coupled to the first output terminal of the first reference voltage generation circuit (14) and further configured to receive the preset power supply signal, and generate, under driving of the preset power supply signal and based on each data combination, the target data signal.

3. The data transmitting circuit (10) according to claim 2, the data transmitting circuit (10) further comprising:

   a clock generation circuit (15), coupled to the parallel-to-serial conversion circuit (11) and configured to generate the initial clock signal and output the initial clock signal through an output terminal of the clock generation circuit;
   a DC blocking circuit (16), connected to the output terminal of the clock generation circuit (15) and the second output terminal of the first reference voltage generation circuit (14) separately, and configured to transmit the initial clock signal subjected to direct-current blocking processing to the second output terminal of the first reference voltage generation circuit (14), so as to be superimposed with the initial reference voltage signal to generate a clock/voltage mixed signal; and

a second transmission path (18), coupled to the second output terminal of the first reference voltage generation circuit (14) and configured to output the clock/voltage mixed signal from the first chip (51).

4. The data transmitting circuit (10) according to claim 3, wherein in a case that n = 2, the data combination comprises a low-bit data signal and a high-bit data signal;
if the low-bit data signal and the high-bit data signal form a first signal value combination, the target data signal is a first voltage value; if the low-bit data signal and the high-bit data signal form a second signal value combination, the target data signal is a second voltage value; if the low-bit data signal and the high-bit data signal form a third signal value combination, the target data signal is a third voltage value; if the low-bit data signal and the high-bit data signal form a fourth signal value combination, the target data signal is a grounding voltage; and the first voltage value, the second voltage value, the third voltage value, and the grounding voltage decrease sequentially.

5. The data transmitting circuit (10) according to claim 4, wherein

the multi-level modulation circuit (12) comprises a first logic unit (121), a first pull-up unit (122), a second pull-up unit (123), a third pull-up unit (124), and a pull-down unit (125);
the multi-level modulation circuit (12) further comprises a driving source node and an output node, wherein the driving source node receives the preset power supply signal; the first pull-up unit (122), the second pull-up unit (123), and the third pull-up unit (124) are connected in parallel between the driving source node and the output node;
the pull-down unit 125 is connected in series between the output node and a ground terminal, and the output node is connected to the first transmission path (13); and
the first logic unit (121) is configured to perform an AND operation on the low-bit data signal and the high-bit data signal to generate a first control signal, and perform a NOR operation on the low-bit data signal and the high-bit data signal to generate a second control signal,
wherein the first control signal is configured to selectively turn on the first pull-up unit (122), the high-bit data signal is configured to selectively turn on the second pull-up unit (123), the low-bit data signal is configured to selectively turn on the third pull-up unit (124), the second control signal is configured to selectively turn on the pull-down unit (125), and resistance values of the second pull-up unit (123) and the third pull-up unit (124) are different.

6. The data transmitting circuit (10) according to claim 5, wherein the first pull-up unit (122) comprises a first switching transistor (211) and a first resistor (212) connected in series between the driving source node and the output node, the second pull-up unit (123) comprises a second switching transistor (213) and a second resistor (214) connected in series between the driving source node and the output node, the third pull-up unit (124) comprises a third switching transistor (215) and a third resistor (216) connected in series between the driving source node and the output node, and the pull-down unit (125) comprises a fourth switching transistor (217) and a fourth resistor (218) connected in series; and
a control terminal of the first switching transistor (211) receives the first control signal, a control terminal of the second switching transistor (213) receives the low-bit data signal, a control terminal of the third switching transistor (215) receives the high-bit data signal, and a control terminal of the fourth switching transistor (217) receives the second control signal.

7. The data transmitting circuit (10) according to claim 6, wherein

the first voltage value:the second voltage value:the third voltage value = A:B:C, wherein A, B, and C are all positive integers, and A, B, and C decrease sequentially;

$$(R_{parallel} + R_{down}):(R_2 + R_{down}):(R_3 + R_{down}) = (1/A):(1/B):(1/C),$$

wherein $R_{parallel}$ refers to an equivalent resistance formed by connecting the first resistor (212), the second resistor (214), and the third resistor (216) in parallel, $R_{down}$ refers to a resistance value of a pull-down resistor (39) coupled to the first transmission path (13) in a data receiving circuit (30) corresponding to the data transmitting circuit (10), $R_2$ refers to a resistance value of the second resistor (214), and $R_3$ refers to a resistance value of the third resistor (216).

8. The data transmitting circuit (10) according to any one of claims 2 to 7, wherein the first reference voltage generation circuit (14) comprises a first operational amplifier (221), a fifth resistor (222), and a sixth resistor (223);

a positive input terminal of the first operational amplifier (221) receives the reference voltage signal, a negative input terminal of the first operational amplifier (221) is connected to an output terminal of the first operational amplifier (221), and the output terminal of the first operational amplifier (221) serves as the first output terminal of the first reference voltage generation circuit (14) to output the preset power supply signal; and

the output terminal of the first operational amplifier (221) is connected to a first terminal of the fifth resistor (222), a second terminal of the fifth resistor (222) is connected to a first terminal of the sixth resistor (223), a second terminal of the sixth resistor (223) is connected to the ground terminal, and the second terminal of the fifth resistor (222) serves as the second output terminal of the first reference voltage generation circuit (14) to output the initial reference voltage signal.

9. The data transmitting circuit (10) according to any one of claims 3 to 8, wherein
the first transmission path (13) and the second transmission path (18) each comprise a through silicon via.

10. A data receiving circuit (30), applied to a second chip (52), the data receiving circuit (30) comprising:

a third transmission path (31), configured to receive a target data signal transmitted to the second chip (52);
a data comparison circuit (32), coupled to the third transmission path (31) and configured to receive $(2^n - 1)$ reference voltages and the target data signal, compare a voltage value of each of the reference voltages with a voltage value of the target data signal, and generate and output $(2^n - 1)$ comparison signals; and
a logic processing circuit (33), coupled to the data comparison circuit (32) and configured to perform logic processing on the $(2^n - 1)$ comparison signals to generate and output a data combination, wherein each data combination comprises an n-bit data signal, and n is an integer greater than 1.

11. The data receiving circuit (30) according to claim 10, the data receiving circuit (30) further comprising:

a fourth transmission path (34), configured to receive a clock/voltage mixed signal transmitted to the second chip (52);
a clock receiver (35), coupled to the fourth transmission path (34) and configured to receive a clock reference voltage and a clock/voltage mixed signal, compare the clock/voltage mixed signal with the clock reference voltage, and generate and output a reference clock signal;
a clock processing circuit (36), connected to the clock receiver (35) and configured to receive the reference clock signal, process the reference clock signal, and then generate and output a sampling clock signal; and
a logic processing circuit (33), further connected to the clock processing circuit (36) and configured to sample the $(2^n - 1)$ comparison signals separately based on the sampling clock signal, and perform a logical operation based on a sampling result to generate the data combination.

12. The data receiving circuit (30) according to claim 11, the data receiving circuit (30) further comprising:

a low-pass filter (37), configured to receive the clock/voltage mixed signal and filter the clock/voltage mixed signal to generate an initial reference voltage; and
a second reference voltage generation circuit (38), configured to generate $(2^n - 1)$ reference voltages based on the initial reference voltage.

13. The data receiving circuit (30) according to claim 12, the data receiving circuit (30) further comprising a pull-down resistor (39), wherein
a first terminal of the pull-down resistor (39) is connected to the third transmission path (31), and a second terminal of the pull-down resistor (39) is connected to a ground terminal.

14. The data receiving circuit (30) according to claim 12 or 13, wherein in a case that n = 2, the $(2^n - 1)$ reference voltages are referred to as a first reference voltage, a second reference voltage, and a third reference voltage, respectively, and the $(2^n - 1)$ comparison signals are referred to as a first comparison signal, a second comparison signal, and a third comparison signal, respectively;

a voltage value of the first reference voltage is between a first voltage value and a second voltage value, a voltage value of the second reference voltage is between the second voltage value and a third voltage value, and a voltage value of the third reference voltage is between the third voltage value and a grounding voltage; the first voltage value, the second voltage value, and the third voltage value decrease sequentially; and
the logic processing circuit (33) is specifically configured such that: if the first comparison signal indicates that the voltage value of the target data signal is greater than or equal to the voltage value of the first reference voltage, a two-bit data signal of the data combination forms a first signal value combination; or

if the first comparison signal indicates that the voltage value of the target data signal is less than the voltage value of the first reference voltage and the second comparison signal indicates that the voltage value of the target data signal is greater than or equal to the voltage value of the second reference voltage, a two-bit data signal of the data combination forms a second signal value combination; or

if the second comparison signal indicates that the voltage value of the target data signal is less than the voltage value of the second reference voltage and the third comparison signal indicates that the voltage value of the target data signal is greater than or equal to the voltage value of the third reference voltage, a two-bit data signal of the data combination forms a third signal value combination; or

if the third comparison signal indicates that the voltage value of the target data signal is less than the voltage value of the third reference voltage, a two-bit data signal of the data combination forms a fourth signal value combination.

15. The data receiving circuit (30) according to claim 14, wherein the second reference voltage generation circuit (38) comprises a second operational amplifier (381), a seventh resistor (382), an eighth resistor (383), a ninth resistor (384), and a tenth resistor (385);

a positive input terminal of the second operational amplifier (381) receives the initial reference voltage, an output terminal of the second operational amplifier (381) is connected to a first terminal of the seventh resistor (382), and a negative input terminal of the second operational amplifier (381) is connected to a second terminal of the eighth resistor (383);

a second terminal of the seventh resistor (382) is connected to a first terminal of the eighth resistor (383), the second terminal of the eighth resistor (383) is connected to a first terminal of the ninth resistor (384), a second terminal of the ninth resistor (384) is connected to a first terminal of the tenth resistor (385), and a second terminal of the tenth resistor (385) is connected to the ground terminal; and

the second terminal of the seventh resistor (382) outputs the first reference voltage, the second terminal of the eighth resistor (383) outputs the second reference voltage, and the second terminal of the ninth resistor (384) outputs the third reference voltage.

16. The data receiving circuit (30) according to claim 15, wherein

the second reference voltage is the same as the initial reference voltage, and the clock reference voltage is identical to the second reference voltage; and

the third transmission path (31) and the fourth transmission path (34) each comprise a through silicon via.

17. An electronic device (50), the electronic device (50) comprising a first chip (51) and a second chip (52), wherein the first chip (51) comprises the data transmitting circuit (10) according to any one of claims 1 to 9, and the second chip (52) comprises the data receiving circuit (30) according to any one of claims 10 to 16.

18. The electronic device (50) according to claim 17, wherein the first chip (51) is a logic chip/memory chip, and the second chip (52) is a memory chip/logic chip;

the first chip (51) and the second chip (52) are stacked in a first direction, and the first direction is perpendicular to a top surface of the chip; and

the electronic device (50) is a stacked memory.

19. The electronic device (50) according to claim 18, wherein

a through silicon via in a first transmission path (13) of the first chip (51) and a through silicon via in a third transmission path (31) of the second chip (52) are aligned in the first direction and form a transmission path for a target data signal; and

a through silicon via in a second transmission path (18) of the first chip (51) and a through silicon via in a fourth transmission path (34) of the second chip (52) are aligned in the first direction and form a transmission path for a clock/voltage mixed signal.

51

First chip

10

Data transmitting circuit

11

Initial clock signal → Parallel-to-serial conversion module

Initial data signal (parallel) →

Data combination (serial) → 12 → Multi-level modulation circuit → Target data signal → 13 → First transmission path →

52

Second chip

FIG. 1

14

First reference voltage generation circuit

Reference voltage signal → 221

222

223

Initial reference voltage signal

Clock/Voltage mixed signal

18

TSV

16

Preset power supply signal

11

Parallel-to-serial conversion module

Data combination (serial) → Multi-level modulation circuit → 12

Target data signal → 13 → TSV

15

Clock module

17

FIG. 2

Voltage value of target
data signal

Data<1:0>

V1

11

Ref-H

V2

10

Ref-M

V3

01

Ref-L

VSS

0 0

0

FIG. 3

12

Preset power supply signal

Driving source node

Data<1>
Data<0>

201

121

122
211

123

124

202

213

203

215

212

214

216

13

TSV

218

Output node

Target data signal

204

217

125

FIG. 4

52

Second chip

30

Data receiving circuit

51

31

$2^n - 1$
reference voltages

32

$2^n - 1$
comparison
signals

33

n-bit data
signal

First chip

Third
transmission
path

Target data signal

Data
comparison
circuit

Logic
circuit

FIG. 5

FIG. 6

50

⋮ ⋮       ⋮ ⋮

| Memory chip |

| Memory chip |

Third
direction

First chip
(Memory chip) — 51

TSV            TSV

Target data
signal

Clock/Voltage
mixed signal

TSV  Second chip  TSV — 52
(Logic chip)

**FIG. 7A**

50

⋮ ⋮       ⋮ ⋮

| Memory chip |

| Memory chip |

Third
direction

Second chip — 52
(Memory chip)

TSV            TSV

Target data
signal

Clock/Voltage
mixed signal

TSV  First chip  TSV — 51
(Logic chip)

**FIG. 7B**

FIG. 7C

FIG. 8

## INTERNATIONAL SEARCH REPORT

| International application No. |
| --- |
| **PCT/CN2024/107372** |

| | |
| --- | --- |
| **A. CLASSIFICATION OF SUBJECT MATTER**<br><br>G11C 5/14(2006.01)i<br><br>According to International Patent Classification (IPC) or to both national classification and IPC | |

**B. FIELDS SEARCHED**

Minimum documentation searched (classification system followed by classification symbols)

    IPC:G11C

Documentation searched other than minimum documentation to the extent that such documents are included in the fields searched

Electronic data base consulted during the international search (name of data base and, where practicable, search terms used)

    VEN, CNABS, CNTXT, WOTXT, EPTXT, USTXT, CNKI, IEEE: 数据, 接收, 电路, 电压, 参考, 信号, 比较, 并行, 串行, 转换, 传输, 输出, 芯片, data, receiving, circuit, voltage, reference, signal, comparison, parallel, serial, convert, transmission, output, chip

**C. DOCUMENTS CONSIDERED TO BE RELEVANT**

| Category* | Citation of document, with indication, where appropriate, of the relevant passages | Relevant to claim No. |
| --- | --- | --- |
| A | CN 114024544 A (CHANGXIN MEMORY TECHNOLOGIES, INC.) 08 February 2022 (2022-02-08)<br>    claims 1-21, and description, paragraphs [0030]-[0114] | 1-9, 17-19 |
| A | CN 112769416 A (CHENGDU HAIGUANG MICROELECTRONICS TECHNOLOGY CO., LTD.) 07 May 2021 (2021-05-07)<br>    claims 1-12, and description, paragraphs [0053]-[0110] | 10-19 |
| A | CN 115694512 A (CHANGXIN MEMORY TECHNOLOGIES, INC.) 03 February 2023 (2023-02-03)<br>    entire document | 1-19 |
| A | US 2006001448 A1 (SEO, Dong-il et al.) 05 January 2006 (2006-01-05)<br>    entire document | 1-19 |

☐ Further documents are listed in the continuation of Box C.     ☑ See patent family annex.

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
| --- | --- |
| **14 September 2024** | **12 October 2024** |

| Name and mailing address of the ISA/CN | Authorized officer |
| --- | --- |
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
**Information on patent family members**

International application No.

**PCT/CN2024/107372**

| Patent document cited in search report | | | Publication date (day/month/year) | Patent family member(s) | | | Publication date (day/month/year) |
|---|---|---|---|---|---|---|---|
| CN | 114024544 | A | 08 February 2022 | US | 2023378955 | A1 | 23 November 2023 |
| | | | | WO | 2023130588 | A1 | 13 July 2023 |
| CN | 112769416 | A | 07 May 2021 | None | | | |
| CN | 115694512 | A | 03 February 2023 | None | | | |
| US | 2006001448 | A1 | 05 January 2006 | KR | 20060003173 | A | 10 January 2006 |
| | | | | US | 2008211542 | A1 | 04 September 2008 |
| | | | | JP | 2006025423 | A | 26 January 2006 |

Form PCT/ISA/210 (patent family annex) (July 2022)

**EP 4 715 817 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202311868889